Europäisches Patentamt

European Patent Office

Office européen des brevets

(11) Veröffentlichungsnummer : **0 500 618 B1**

(12) **EUROPÄISCHE PATENTSCHRIFT**

(45) Veröffentlichungstag der Patentschrift :
11.01.95 Patentblatt 95/02

(51) Int. Cl.$^6$ : **G01R 33/38**

(21) Anmeldenummer : 90916245.5

(22) Anmeldetag : 07.11.90

(86) Internationale Anmeldenummer :
PCT/DE90/00842

(87) Internationale Veröffentlichungsnummer :
WO 91/07669 30.05.91 Gazette 91/12

(54) GRADIENTENERZEUGUNGSSYSTEM, KERNSPINTOMOGRAPH UND VERFAHREN ZUR BILDERZEUGUNG MIT EINEM KERNSPINTOMOGRAPHEN.

(30) Priorität : 08.11.89 DE 3937148

(43) Veröffentlichungstag der Anmeldung :
02.09.92 Patentblatt 92/36

(45) Bekanntmachung des Hinweises auf die
Patenterteilung :
11.01.95 Patentblatt 95/02

(84) Benannte Vertragsstaaten :
FR GB NL

(56) Entgegenhaltungen :
EP-A- 0 073 399
EP-A- 0 250 718
EP-A- 0 317 775
DE-A- 3 907 141
PATENT ABSTRACTS OF JAPAN, vol. 11, no.
112 (P-565)(2559), 9 April 1987 ; &
JP-A-61260150

(56) Entgegenhaltungen :
PATENT ABSTRACTS OF JAPAN, vol. 13, no.
331 (C-622)(3679), 25 July 1989 ; & JP-
A-1110354
Journal of Physics E : Scientific Instruments,
vol. 21, No. 6, June 1988, IOP Publishing Ltd.,
(Bristol, GB), R. Pouladian-Kari et al. : "A
multiple coil solenoid to provide an axial magnetic field with near-linear gradient", pages
557-559.

(73) Patentinhaber : Bruker Analytische
Messtechnik GmbH
Silberstreifen
D-76287 Rheinstetten (DE)

(72) Erfinder : MÜLLER, Wolfgang Hans-Georg
Kösliner Strasse 48a
W-7500 Karlsruhe 1 (DE)

(74) Vertreter : KOHLER SCHMID + PARTNER
Patentanwälte
Ruppmannstrasse 27
D-70565 Stuttgart (DE)

## Beschreibung

Die Erfindung betrifft ein System von durch ein Netzgerät gespeisten Gradientenspulen zum Erzeugen magnetischer Gradientenfelder, die sich dem statischen Magnetfeld eines Kernspintomographen zeitweise überlagern, welches mindestens ein Paar von Gradientenspulen umfaßt, die im Betrieb in Serie von Strom durchflossen werden und in einem vorgegebenen Untersuchungsvolumen ein wenigstens näherungsweise mit dem Ort in einer Richtung linear variierendes Gradientenmagnetfeld erzeugen, wobei jede Gradientenspule einen ersten Wicklungsabschnitt oder einen ersten Satz von Wicklungsabschnitten und einen zweiten Wicklungsabschnitt oder einen zweiten Satz von Wicklungsabschnitten aufweist, wobei die Anschlüsse des ersten Wicklungsabschnittes oder ersten Satzes von Wicklungsabschnitten von den Anschlüssen des zweiten Wicklungsabschnittes oder zweiten Satzes von Wicklungsabschnitten getrennt sind. Bei einem derartigen aus der DE-A1-39 07 141 bekannten System wird zur Verringerung der elektrischen Belastung von Halbleiterelementen jeder Wicklungsabschnitt mit einem gesonderten Einheitstreiber zum Zuführen des für die Gradientenerzeugung erforderlichen Stroms verbunden. Die zum Beispiel zwei Wicklungsabschnitte einer Gradientenspule können so betrieben werden, daß sie von Strömen in gleicher Richtung durchflossen werden, oder daß nur ein einziger Wicklungsabschnitt von einem Strom durchflossen wird.

Die Erfindung betrifft außerdem einen Kernspintomographen mit einem derartigen Gradientenerzeugungssystem und ein Verfahren zur Bilderzeugung mit einem derartigen Kernspintomographen.

Kernspintomographen, ihre Funktionsweise und mögliche bildgebende Verfahren sind in der Fachliteratur ausführlich beschrieben (z.B. "Medizinische Physik", 1983, Hüthig-Verlag, Hrsg.: J. Schütz). An ein zu untersuchendes Objekt werden neben einem möglichst homogenen statischen Magnetfeld Bo zeitweise auch magnetische Gradientenfelder angelegt. Ein Gradientenfeld ist ein Magnetfeld, das die Richtung von Bo hat, seine Stärke variiert aber möglichst linear mit dem Ort in einer Richtung und ist rechtwinklig dazu konstant. Im allgemeinen werden insgesamt drei unterschiedliche Gradientenfelder benutzt, die durch ein Gradientenerzeugungssystem mit einer Mehrzahl von Gradientenspulen erzeugt werden, wobei die Richtungen der entsprechenden Gradienten rechtwinklig aufeinander stehen ($Gz = dBz/dZ$; $Gx = dBz/dx$; $Gy = dBz/dy$), wobei die z-Richtung mit der Richtung von Bo übereinstimmt.

Die lineare Änderung der Feldstärke (konstanter Verlauf des Gradienten) soll möglichst über das gesamte Untersuchungsobjekt bestehen. Dies stellt Anforderungen an die Gradientenspulen, mit denen die Gradientenfelder im allgemeinen erzeugt werden. Solche Spulen sind z.B. im Artikel von J. Heinzerling in der obengenannten Schrift auf Seite 59 dargestellt und beschrieben. In Tomographen mit solenoidartiger Hauptfeldspule (für Bo) wird der Gradient Gz im allgemeinen mit einer sogenannten Anti-Helmholtz-Anordnung erzeugt, und die Gradienten Gx und Gy werden mit Anordnungen von je vier Sattelspulen erzeugt. Für andere Magnettypen, z.B. "H-Magnet" (vgl. DE 36 16 078), "Window-Frame" (vgl. EP 181 383), oder dem in EP 167 639 beschriebenen Typ sind andere an die jeweilige Geometrie angepaßte Gradientenspulensätze bekannt. Diese sind zum großen Teil aus dem Gebiet der analytischen NMR übernommen, wo solche Spulen als statische Feldkorrekturspulen ("Shimspulen") seit langem eingesetzt werden.

Bei Verwendung zylindrischer Spulen als Gradientenspulen sind zum Erzeugen des Gradienten im einfachsten Fall nur zwei Spulen, die das eingangs genannte Paar bilden, nötig. Bei Verwendung von Sattelspulen sind für einen Gradienten, wie soeben erwähnt, vier Sattelspulen nötig, von denen je zwei eine einzige Spule des Paars in der Ausdrucksweise der Erfindung bilden und die vier Sattelspulen somit das genannte Paar bilden.

Je nach Auslegung der Gradientenspulen entsprechen die wahren Gradientenverläufe den gewünschten (konstanten) Gradientenverläufen nur über einen begrenzten Volumenbereich, der oft kleiner als das Meßobjekt ist. Daher sind Anstrengungen unternommen worden, diesen Bereich zu vergrößern. Dies muß natürlich unter Einhaltung gewisser Randbedingungen geschehen. Bei solenoidartiger Hauptspule sind die Wicklungen der Gradientenspulen auf einen Zylindermantel beschränkt. Lösungsvorschläge, die im wesentlichen die für Shimspulensätze bekannten Maßnahmen übernehmen, sind z.B. in den europäischen Patenten EP-B-73399 und 73402 beschrieben. Solche Lösungen, die in der Lage sind, höhere Ordnungen einer Gradientenfeldentwicklung zu Null zu machen, erfordern mehr Spulen oder doch mehr Windungen als die einfache Lösung. Außerdem ist meistens das erzielte Gradientenfeld bei Verwendung von Spulen höherer Ordnung zwar homogener, aber auch kleiner als bei einfachen Spulen, wenn man in beiden Fällen den gleichen Erregerstrom voraussetzt.

Die meisten bildgebenden Verfahren in der Kernspintomographie arbeiten mit Hochfrequenzpulssequenzen, wobei auch die Gradientenfelder pulsartig ein- und ausgeschaltet werden. Dabei müssen die Schaltvorgänge meistens möglichst kurz und dennoch definiert und reproduzierbar sein. Der Idealfall ist ein rechteckförmiger Zeitverlauf oder doch zumindest ein etwa trapezförmiger Zeitverlauf mit möglichst steiler Flanke im Millisekundenbereich. Bei gegebener Induktivität der Spulenanordnung erfordert eine steilere Anstiegsflanke

2

ein stärkeres Gradientennetzgerät zum Versorgen der Gradientenspulen mit Strom. Daher ist es wünschenswert, die Induktivität möglichst klein zu halten, was der Forderung nach großem Linearitätsbereich widerspricht.

Gepulste Gradientenfelder mit Anstiegszeiten im Bereich einer Millisekunde induzieren in den umgebenden leitfähigen Strukturen Wirbelströme, die wiederum zu zeitlichen und räumlichen Feldverzerrungen führen. Eine Möglichkeit, diesem Problem zu begegnen, ist die Verwendung "selbstabschirmender" Gradientenerzeugungssysteme. Dabei sind die Gradientenspulen außen von ähnlichen Spulen umgeben, durch die ein jeweils gegenläufiger Strom geschickt wird. Diese Anordnung ist so ausgelegt, daß sich die Gesamtmagnetfelder außerhalb weitgehend kompensieren, im Inneren jedoch ein (möglichst konstantes) Gradientenfeld bleibt. Da man mehr Spulen zur Verfügung hat, kann man sowohl Gradientenerzeugung als auch Abschirmfunktion optimieren. Nachteile sind eine deutlich reduzierte Gradientenstärke bei gleichem Erregerstrom. Selbstabschirmende Gradientenerzeugungssysteme sind beispielsweise in der EP-A-231 879, US-A-4 733 189 und DE-A-3 808 995 beschrieben.

Da die bekannten Gradientenerzeugungssysteme widersprüchlichen Anforderungen genügen müssen (maximale Gradientenstärke, großer Homogenitäts- bzw. Linearitätsbereich, kurze Anstiegszeiten, keine Wirbelstrominduktion, usw.) können sie grundsätzlich nicht für jeden wichtigen Gesichtspunkt optimiert sein. Die bekannten Kernspintomographen besitzen ein einziges Gradientenerzeugungssystem (das die oben genannten drei Gradientenrichtungen umfaßt), das entweder so ausgelegt ist, daß es einen Kompromiß für möglichst alle Kriterien bildet (Universalsystem), oder das auf besondere Wünsche des Betreibers hin optimiert ist. Sollten sich diese Wünsche ändern, ist dies nur über einen Austausch des Gradientenerzeugungssvstems möglich. Insbesondere ist es nicht möglich, während einer einzigen Messung (Aufnahme eines Tomographie-Bilds) oder während einer einzigen Meßserie die Charakteristik des Gradientenerzeugungssystems zu ändern.

Die EP-A-156 442 spricht zwar davon, eine Art Kombination von Shim- und Gradientenerzeugungssystem so zu betreiben, daß "der gewünschte räumlich-zeitliche Magnetfeldverlauf" erzielt wird. Dies ist jedoch so zu verstehen, daß eine Vielzahl komplizierter Spulensysteme über unabhängige Netzgeräte angesteuert werden. Der gewünschte zeitlich-räumliche Verlauf verlangt sehr oft Ströme, die die Netzgeräte nicht liefern können, oder Toleranzen, die nicht eingehalten werden können. Außerdem ist der Aufbau sehr kompliziert und teuer.

Aufgabe der Erfindung ist es, ein relativ einfaches Gradientenerzeugungssystem bereitzustellen, das vom Benutzer in einfacher Weise für mindestens zwei unterschiedliche Betriebsarten verwendet werden kann.

Diese Aufgabe wird durch die im kennzeichnenden Teil des Anspruches 1 angegebenen Maßnahmen gelöst. Der erfindungsgemäße Kernspintomograph weist ein erfindungsgemäßes Gradientenerzeugungsystem auf, und die für dieses zutreffendenden Vorteile gelten auch für den Kernspintomographen. Das erfindungsgemäße Verfahren zur Bilderzeugung sieht vor, daß das Gradientenerzeugungssystem gesteuert umgeschaltet wird, so daß innerhalb einer Pulssequenz jeweils die für den betreffenden Zeitpunkt der Pulssequenz optimalen Gradienten wirksam sind.

Der Erfindung liegt die Erkenntnis zugrunde, daß es mehrere Eigenschaften eines Gradientenerzeugungssystems gibt, die beim Einsatz in einem Kernspintomographen unbedingt vorhanden sein müssen, daß aber nie alle diese Eigenschaften gleichzeitig erforderlich sind. Es gibt bildgebende Verfahren (oder innerhalb des Verfahrens Zeitbereiche), die an bestimmte Eigenschaften sehr hohe Anforderungen stellen, während andere Eigenschaften recht unwichtig sind. In einem anderen Verfahren (oder Zeitbereich) können die Gruppierungen von wichtigen und unwichtigen Eigenschaften wieder ganz anders sein. Die Erfindung hat erkannt, daß es möglich ist, Gradientenerzeugungssvsteme zu konstruieren, die durch einfaches elektrisches Umschalten jeweils andere Gruppen von Eigenschaften optimieren und zwar solche, die in der Praxis besonders wichtig sind. Dabei deckt die Gesamtheit der Betriebsarten (vorzugsweise zwei) nach wie vor den gesamten Bereich der möglichen Anwendungen ab.

So kann das System bei Ausführungsformen der Erfindung beispielsweise zur Erzeugung starker Gradienten durch einfache Spulen ausgelegt sein. Dabei sind zwar kurze Anstiegszeiten möglich, der Linearitätsbereich ist jedoch zwangsläufig klein. Das System ist aber für sich durchaus arbeitsfähig und in vielen Anwendungen ausreichend. Das Zuschalten zusätzlicher Linearisierungsspulen erhöht zwar die Induktivität und damit die Anstiegszeiten, vergrößert aber den linearen Bereich. Beide Schaltzustände oder Betriebsarten repräsentieren arbeitsfähige Gradientenerzeugungssysteme.

Das Umschalten zwischen den beiden Schaltzuständen ist bei Ausführungsformen der Erfindung auch innerhalb einer Messung, ja sogar innerhalb einer Pulssequenz möglich. So werden je nach Position in der Pulssequenz unterschiedliche Anforderungen an z.B. Scheiben-, Phasen-, und Lesegradient gestellt, beispielsweise muß der Scheibengradient nicht besonders linear verlaufen, manche Gradienten müssen schneller geschaltet werden als andere. Daher ist es auch möglich, je nach augenblicklichem Erfordernis, z.B. je nach der Richtung der ausgewählten Scheibe, die verschiedenen Gradienten in der x-, y- oder z-Richtung in wechselnden Kombinationen der schaltbaren Spulen-Konfigurationen zu betreiben.

Bei selbstabschirmenden Gradientenerzeugungssystemen kann in bestimmten bildgebenden Verfahren auf die Abschirmung vollkommen verzichtet werden. Man kann statt dessen die äußeren Spulen gleichsinnig mit den inneren mit Strom versorgen, so daß sich die Gradientenfelder addieren. Man verzichtet dabei auf die Abschirmung und einen Teil der Linearität, optimiert aber die Gradientenfeldstärke. Wie im obigen Fall ist es wichtig, daß beide Betriebsarten funktionsfähige Systeme darstellen.

Durch die Erfindung kann man also mit einem vergleichbaren Aufwand wie für ein gut linearisiertes selbstabschirmendes System, das notwendigerweise im Schaltverhalten langsam wäre, zwei Systeme realisieren, eines fast ebensoweit linear (selbstabschirmend) und ein schnelles und/oder starkes System. Die Umschaltung wird je nach aktueller Anforderung oder Probengröße erfolgen.

In manchen Fällen wird es möglich sein, die beiden Betriebsarten mit den extrem linearisierten bzw. selbstabschirmenden Gradientenerzeugungssystemen aus dem Stand der Technik zu realisieren, wobei diese bekannten Systeme so modifiziert werden müssen, daß die Ströme in Teilwicklungen (hierzu zählen auch Teilspulen) zum Zweck des Umschaltens geändert, insbesondere abgeschaltet oder umgepolt, werden können.

Es sind weitere Kombinationen und Ausführungsformen der Elemente der Erfindung möglich. So kann ein Teilsystem zu- oder abgeschaltet werden, aber auch die Polarität des Stroms und/oder die Stromstärke kann verändert werden. Demgemäß können die Teilsysteme von einem Netzgerät in Serie oder unabhängig voneinander betrieben werden, wodurch ein neuer Freiheitsgrad für die Optimierung geschaffen wird. Allerdings ist es vorteilhaft, wenn die Teilsysteme in Serie betrieben werden. Es können Umschaltungen zwischen mehr als zwei Betriebsarten vorgesehen sein.

Bei einer Ausführungsform der Erfindung sind die ersten Wicklungsabschnitte beider Gradientenspulen des Paars miteinander fest in Serie geschaltet und die zweiten Wicklungsabschnitte beider Gradientenspulen des Paars sind miteinander fest in Serie geschaltet. Dadurch sind im Bereich zwischen diesen Spulen keine Umschaltungen nötig.

Je nachdem, wie schnell das Umschalten zwischen den verschiedenen Betriebsarten erfolgen muß, kann es erforderlich sein, wie bei Ausführungsformen der Erfindung vorgesehen, steuerbare elektrische oder elektronische Schalter vorzusehen, die von Hand oder automatisch, insbesondere durch Steuerausgänge eines Impulssteuergeräts für das Gradientennetzgerät ferngesteuert werden können. Wenn dagegen für die Umschaltung viel Zeit zur Verfügung steht, z.B. mehrere Minuten, kann das Umschalten auch von Hand mittels Umsteckvorrichtungen oder mittels handbetätigter Schalter erfolgen. Von der Erfindung erfaßt werden sollen auch Ausführungsformen, bei denen das Umschalten zwischen den Betriebsarten ein Umlöten von Wicklungsanschlüssen der Gradientenspulen erfordert, wobei diese Wicklungsanschlüsse für den Benutzer leicht zugänglich angeordnet sein müssen.

Ausführungsbeispiele der Erfindung werden nun anhand der Zeichnung, die erfindungswesentliche Einzelheiten zeigt, beschrieben. Es zeigen:

| | |
|---|---|
| Fig. 1 | ein erstes Ausführungsbeispiel mit zwei zweilagigen Spulen in Anti-Helmholtz-Anordnung zur Erzeugung des z-Gradienten, |
| Fig. 2a bis c | Beispiele von möglichen Schaltungen für die Spulen der Fig. 1, |
| Fig. 3 | ein zweites Ausführungsbeispiel einer Spulenanordnung mit vier zweilagigen Einzelspulen zur Erzeugung des z-Gradienten, |
| Fig. 4a und b | Beispiele von möglichen Schaltungen für die Spulen der Fig. 3, |
| Fig. 5 | ein drittes Ausführungsbeispiel mit vier zweilagigen Spulen zur Erzeugung des z-Gradienten, |
| Fig. 6a bis c | Beispiele von möglichen Schaltungen für die Spulen der Fig. 5, |
| Fig. 7 | ein viertes Ausführungsbeispiel mit einem Spulensystem aus zweilagigen Spulen, das eine aktive Abschirmung ermöglicht, zur Erzeugung des z-Gradienten, |
| Fig. 8a bis c | Beispiele von möglichen Schaltungen für die Spulen der Fig. 7, |
| Fig. 9 | ein fünftes Ausführungsbeispiel mit einem Spulensystem mit Teilspulen, |
| Fig. 10 | den normierten Feldverlauf für je eine spezielle Anordnung gemäß dem ersten bis dritten Ausführungsbeispiel, |
| Fig. 11 | die relative Gradientenstärke für die gleichen speziellen Anordnungen wie bei Fig. 10, |
| Fig. 12 | schematisch einen Kernspintomographen mit einer Feldspule und Gradientenspulen für drei Gradienten, die über gesteuerte Schaltvorrichtungen mit gesteuerten Netzgeräten verbunden sind, und |
| Fig. 13 | in Ergänzung zu Fig. 1 und 2 weitere Schaltungen. |

Die Beschreibung beschränkt sich auf ein Gradientenerzeugungssystem für einen solenoidartigen Hauptfeldmagneten, und die mit konkreten Zahlenangaben versehenen Ausführungsbeispiele beschreiben lediglich die Gestalt des Gradientenerzeugungssystems, das zur Erzeugung des z-Gradienten dient. Der gewählte Magnettyp ist der bei weitem häufigste, und der z-Gradient theoretisch am einfachsten zu erfassen und am anschaulichsten.

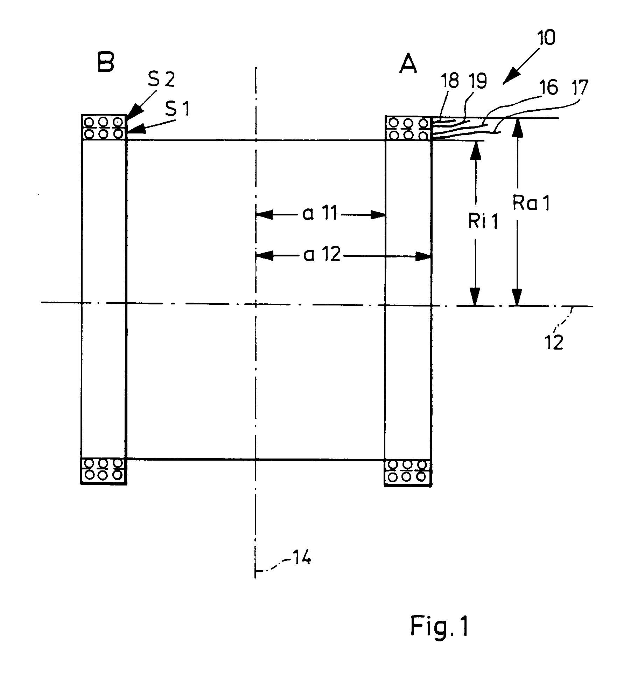

Fig. 1 zeigt eine Spulenanordnung 10 mit zwei völlig gleich ausgebildeten Spulen A und B, die jeweils zwei getrennte Wicklungsabschnitte oder Lagen S1 und S2 von jeweils gleich vielen Windungen haben. Die kreisringförmigen Spulen A und B mit im wesentlichen rechteckigem Wicklungsquerschnitt sind konzentrisch zu einer Achse 12 angeordnet, die gleichzeitig die Achse der nicht gezeigten Feldspule ist, durch die das Gleichfeld Bo für den Kernspintomographen erzeugt wird, zu dem die Spulenanordnung 10 gehört. Die Spulen A und B sind symmetrisch zu einer orthogonal zur Achse 12 verlaufenden Quermittelebene 14 des Magnetsystems, dessen wesentlicher Bestandteil die soeben genannte Feldspule ist.

Der Außenradius Ra1 der beiden Spulen A und B beträgt bei einem konkreten Ausführungsbeispiel 80,8 mm, der Innenradius Ri1 beträgt 76,4 mm. Der Abstand a11 beider Spulen A, B von der Quermittelebene 14 beträgt 59,0 mm, der Abstand a12 beträgt 79,8 mm. Demzufolge beträgt der lichte Abstand beider Spulen 118 mm, und ihre Breite ist 20,8 mm. Jede Spule enthält zwei Lagen von jeweils 13 Windungen und somit insgesamt 26 Windungen. Die einzelnen Lagen S1 und S2 jeder Spule sind mit eigenen elektrischen Anschlüssen 16, 17 für die jeweils innere Lage S1 und 18, 19 für die jeweils äußere Lage S2 versehen, so daß die Möglichkeit besteht, diese einzelnen Lagen oder Wicklungsabschnitte in beliebiger Weise untereinander und mit einem Netzgerät zu verbinden. Alle Wicklungsabschnitte aller Spulen sind mit dem gleichen Wicklungssinn gewickelt. Dies gilt auch für die folgenden Ausführungsbeispiele.

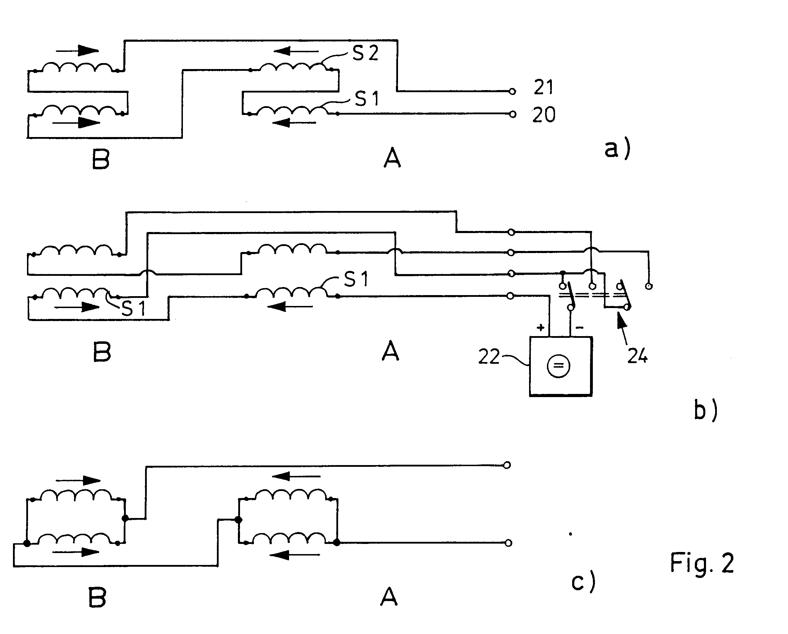

In Fig. 2 sind vorteilhafte Möglichkeiten gezeigt, wie die einzelnen Teilwicklungen der Spulen miteinander verbunden werden können.

Fig. 2a zeigt eine Schaltung, bei der sämtliche Wicklungsabschnitte beider Spulen A und B in Serie geschaltet sind und mit zwei Anschlüssen 20 und 21 verbunden sind. Wenn der Anschluß 20 mit dem positiven Pol einer Gleichspannung verbunden wird und der Anschluß 21 mit dem negativen Pol, so werden die Wicklungsabschnitte vom Strom in der Richtung durchflossen, die sich aus den eingezeichneten Pfeilen ergibt. Es werden die Wicklungsabschnitte der Spule A im gleichen Sinn durchflossen, und auch die Wicklungsabschnitte der Spule B werden im gleichen Sinn vom Strom durchflossen, aber in entgegengesetzter Richtung wie bei der Spule A. Die beiden von den Spulen A und B erzeugten Magnetfelder sind daher einander entgegengerichtet, wodurch sich bekanntlich ein z-Gradient in Richtung der Achse 12, die, wie allgemein üblich, als z-Achse des Magnetsystems bezeichnet wird, ergibt. In der Quermittelebene 14 herrscht dabei das Feld Bo, das von der Feldspule erzeugt wird, und dieses Feld wird entsprechend der Stromrichtung und dem Wicklungssinn der Spulen A und B in Richtung auf diese Spulen zu größer bzw. kleiner. Es versteht sich, daß während einer Messung an der Klemme 20 nicht immer die gleiche Polarität anliegen muß. In Fig. 2a ergibt sich hier eine relativ hohe Gesamtinduktivität und ein starker Gradient, aber auch eine relativ große Anstiegszeit beim plötzlichen Einschalten des Stroms.

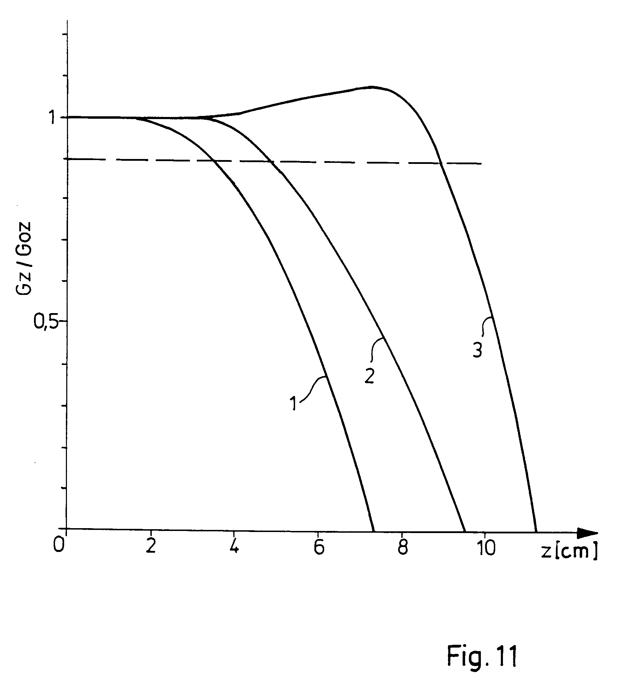

Die Linearität der Anordnung, welche bei einer Abweichung von 10% von dem Wert in der Quermittelebene 14 definiert ist, beträgt hierbei 3,5 cm in z-Richtung, wie aus der für diese Schaltung geltenden Kurve 1 der Fig. 11 hervorgeht.

Fig. 2b zeigt eine Schaltungsanordnung unter Verwendung der Spulenanordnung 10, wobei ein Netzgerät 22 und ein mehrpoliger Umschalter 24 vorgesehen sind, der zwei Schaltstellungen I und II annehmen kann. In der gezeigten Schaltstellung I wird jeweils nur ein Wicklungsabschnitt, und zwar der innere Wicklungsabschnitt S1 jeder Spule A und B vom Strom durchflossen, und zwar im gleichen Sinn wie in Fig. 2a gezeigt ist. Es ergibt sich hierbei eine gegenüber Fig. 2a um den Faktor 4 verminderte Induktivität, dadurch eine um den gleichen Faktor reduzierte Anstiegszeit und ein kleinerer Gradient. In der Stellung II des Schalters 24 werden sämtliche Teilwicklungen genau im gleichen Sinn vom Strom durchflossen wie in Fig. 2a.

In Fig. 2c ist die Anordnung so getroffen, daß die beiden Teilwicklungen jeder Spule A und B zueinander parallel geschaltet sind. Es ergibt sich hierbei die gleiche Induktivität wie bei Fig. 2b in der Stellung I, jedoch ein geringerer ohmscher Widerstand der Wicklungen.

Die Anordnung nach Fig. 2b kann so abgeändert werden, daß die in Fig. 2c gezeigte Verbindung der Wicklungsabschnitte durch Betätigung eines Schalters erreicht werden kann. Daneben besteht die Möglichkeit, wie auch bei den meisten der im folgenden beschriebenen Ausführungsbeispiele, die jeweils gewünschte Zusammenschaltung der Teilwicklungen durch andere Schaltvorrichtungen, z.B. durch elektrische Steckvorrichtungen zu bewirken, oder je nach Bedarf die Anschlüsse der Wicklungsabschnitte durch Lötverbindungen in der gewünschten Weise miteinander zu verbinden.

Tabelle 1 zeigt einige Meßwerte der Spulenanordnung 10 in den gezeigten Schaltungsanordnungen. IA ist der Strom durch eine bzw. beide Wicklungsabschnitte der Spule A, IB entsprechend der Strom in der Spule B. Eine Stromangabe von -40A repräsentiert die bei der Spule B in Fig. 2 gezeigte Stromrichtung, die der Stromrichtung in Spule A entgegengesetzt ist. dBz/dz ist die Größe des Gradienten, gemessen in mT/m. L ist die Gesamtinduktivität der Anordnung, R der gesamte Widerstand. U(stat) ist die statische Spannung, die an dem Netzgerät bei Speisung der Anordnung mit Gleichstrom herrscht.

In diesem Fall wie in allen anderen Fällen wird ein Netzgerät zur Speisung verwendet, das einen Strom von 40 A bei einer Spannung von 40 V liefern kann. In den Tabellen ist T die Anstiegszeit, die benötigt wird, um den Strom von 40 A bei einer Spannung von 40 V zu erreichen. Aufgrund der oben konkret angegebenen Bemessung der Spulenanordnung 10 ergibt sich, daß diese Spulenanordnung 10 in allen in Fig. 2 gezeigten Schaltungsarten eine funktionsfähige Anordnung bildet. Bei hoher Induktivität (Fig. 2a) ist der Gradient groß, bei kleiner Induktivität ist der Gradient kleiner (bei gleichem Strom), aber die Anstiegszeit ebenfalls verringert. Die Linearität ist in beiden Fällen annähernd gleich.

Tabelle 1

| | | IA | IB | dBz/dz | L | R | U (stat) | $\tau$ |
|---|---|---|---|---|---|---|---|---|
| a) | Spule A+B 2 Lagen, Serie | +40A | −40A | 13,3mT/m | 350µH | 0,17Ω | 6,8V | 350µs |
| b) | Spule A+B 1 Lage, Serie,I (II wie a)) | +40A | −40A | 6,6mT/m | 87,5µH | 0,085Ω | 3,4V | 88µs |
| c) | Spule A+B 2 Lagen, parallel | 40A | −40A | 6,6mT/m | 87,5µH | 0,042Ω | 1,7V | 88µs |

Eine weitere Schaltungsmöglichkeit ergibt sich, wenn die Windungszahlen der Lage 1 und 2 unterschiedlich sind. Werden z.B. für die Lage 2 statt 13 Windungen nur 6 Windungen gewählt, so kann mit dieser Teilspule allein eine Induktivität von nur 18,6 µH erreicht werden. Bei einem Betriebsstrom von 40 A und einer Spannung von 40 V erhält man dann eine Gradientenstärke von 3,0 mT/m bei einer Anstiegszeit von 18,6 µs. Wird nur die Lage 1 benutzt, so ergeben sich die Werte in Tabelle 1.b). Bei einer Serienschaltung von Lage 1 und 2 verändern sich die Werte aus Tabelle 1.a), da die Lage 2 weniger Windungen aufweist. Es ergeben sich bei einer Gesamtwindungszahl von 19 eine Gradientenstärke von 9,7 mT/m und eine Anstiegszeit von 197 µs, wobei wiederum ein Betriebsstrom von 40 A und eine Spannung von 40 V angenommen werden. Somit können drei unterschiedliche Betriebsarten mit verschiedenen Gradientenstärken und Anstiegszeiten realisiert werden.

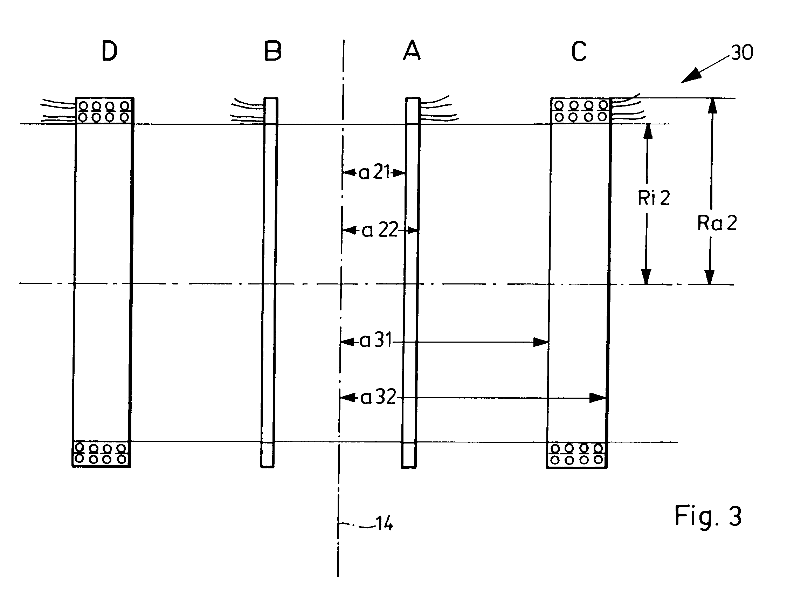

Bei dem in Fig. 3 gezeigten zweiten Beispiel weist eine Spulenanordnung 30 insgesamt vier Spulen A bis D auf. Die Außenradien Ra2 und Innenradien Ri2 sind im Beispiel gleich groß und stimmen bei einem speziellen Ausführungsbeispiel mit den für Fig. 1 angegebenen Maßen genau überein. Die Spulen B und D sind bezüglich der Quermittelebene 14 symmetrisch zu den Spulen A und C angeordnet. Alle Spulen sind wiederum kreisringförmig und koaxial zur Achse 12 angeordnet. Die Abstände der Spule A von der Quermittelebene 14 betragen a21 = 38,4 mm a22 = 43,2 mm, und die entsprechenden Abstände der Spule C von der Quermittelebene 14 betragen a31 = 97,9 mm und a32 = 133,1 mm. Daraus ergibt sich die Breite der Spulen A und B von 4,8 mm und der Spulen C und D von 35,2 mm. Die Spulen A und B weisen jeweils zwei Lagen mit jeweils drei Windungen auf, also insgesamt 6 Windungen. Die Spulen C und D weisen jeweils zwei Lagen mit 22 Windungen auf, also jeweils 44 Windungen. Zur Zeichnungsvereinfachung sind nicht alle Lagen gezeigt. Die Anschlüsse jeder einzelnen Lage bei jeder Spule sind wieder einzeln herausgeführt und können somit in unterschiedlicher Weise miteinander verbunden werden.

Fig. 4 zeigt insgesamt zwei Schaltungen, die sich bei der Anordnung nach Fig. 3 als besonders vorteilhaft erwiesen haben. In Fig. 4a sind die Lagen jeder einzelnen Spule so in Serie geschaltet, daß sich für die einzelne Spule die maximale Induktivität ergibt, und die Spulen A und C werden gleichsinnig vom Strom durchflossen, während die Spulen B und D ebenfalls gleichsinnig vom Strom durchflossen werden, jedoch im umgekehrten Sinn wie die Spulen C und A.

In Fig. 4b werden jeweils nur die inneren Lagen aller Spulen vom Strom durchflossen, und zwar im gleichen Sinn wie in Fig. 4a.

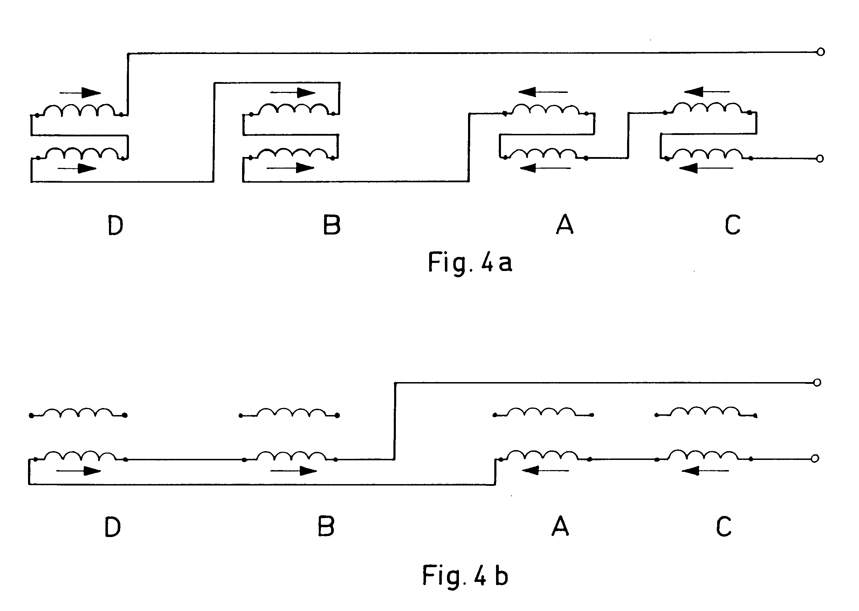

Die Anordnung nach Fig. 3 zeigt im Vergleich zu Fig. 1 eine verbesserte Linearität des magnetischen Feldes in der z-Richtung. Um die gleiche Gradientenstärke bei gleichem Betriebsstrom zu erreichen, muß jedoch eine wesentlich höhere Ampere-Windungszahl und daher eine wesentlich höhere Induktivität in Kauf genommen werden. Die Anstiegszeit vergrößert sich dadurch auf einen Wert von 925µs. Bei einer Schaltungsanordnung nach Fig. 4b erreicht man die kurze Anstiegszeit von nur 250µs. Die gleiche Anstiegszeit mit verringertem Widerstand R würde man erreichen, wenn man in ähnlicher Weise wie in Fig. 2c beide Lagen jeder Spule parallel schaltet.

Tabelle 2 zeigt die Meßwerte der beiden Schaltungen in der Fig. 4.

## Tabelle 2

| | | IA | IB | IC | ID | dBz/dz | L | R | U (stat) | τ |
|---|---|---|---|---|---|---|---|---|---|---|
| a) | Spulen A,B,C,D 2 Lagen, Serie | 40A | −40A | 40A | −40A | 13,3mT/m | 925µH | 0,32Ω | 12,8V | 925µs |
| b) | Spulen A,B,C,D 1 Lage, Serie | 40A | −40A | 40A | −40A | 6,7mT/m | 230µH | 0,16Ω | 6,4V | 230µs |

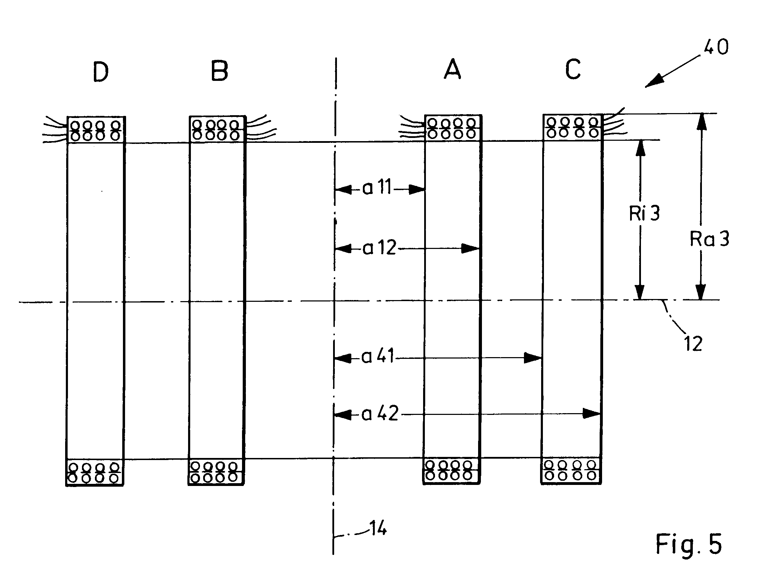

Die in Fig. 5 gezeigte Spulenanordnung 40 weist insgesamt vier Spulen A, B, C und D auf, bei denen im Ausführungsbeispiel die Außenradien Ra3 und die Innenradien Ri3 überall gleich groß sind. Die beiden der Quermittelebene 14 am nächsten liegenden Spulen A und B stimmen mit den Spulen A und B der Fig. 1 völlig überein. Die in Fig. 5 gezeigte Anordnung kann daher, wenn die Spulen C und D völlig abgeschaltet sind, genauso betrieben werden, wie die Anordnung der Fig. 1. Die Spulen A und C einerseits und B und D andererseits können als Teilspulen je einer Gesamtspule AC bzw. BD betrachtet werden.

Der Außenradius Ra3 und der Innenradius Ri3 der äußeren Spulen C und D stimmt mit den entsprechenden Maßen der inneren Spulen A und B überein und beträgt daher 80,8 mm bzw. 76,4 mm.

Die Spulen A und B haben, wie oben angegeben, jeweils 26 Windungen, die ebenfalls zweilagigen Spulen C und D haben zwei mal 12 und somit jeweils insgesamt 24 Windungen.

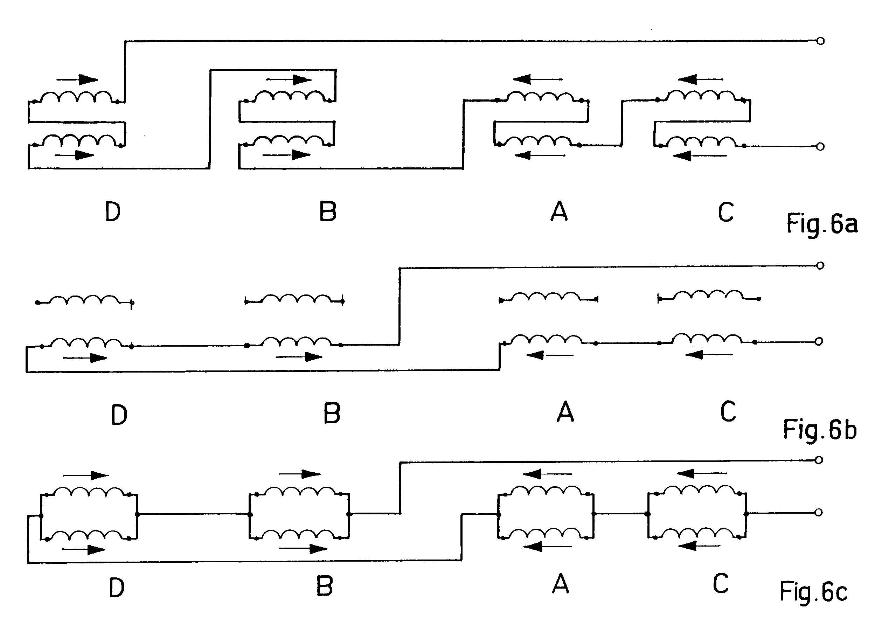

Die kürzeste Schaltzeit erhält man mit der Anordnung der Fig. 5 dann, wenn man die der Fig. 2b entsprechende Schaltung verwendet und somit lediglich die Spulen A und B je einlagig verwendet. Die größte Gradientenstärke mit verbesserter Linearität ergibt sich bei der Schaltung nach Fig. 6a. In diesem Fall sind alle vier Spulen A bis D doppellagig hintereinandergeschaltet, wodurch sich bei einer höheren Gradientenstärke von etwa 18 mT/m eine Verbesserung der Linearität im Vergleich zu den Anordnungen nach Fig. 1 und 3 mit einer Ausdehnung von ca. 5 cm ergibt, wenn die Grenze der Linearität bei 10% Abweichung liegt, vgl. Fig. 11, Kurve 2. Die Anordnung nach Fig. 5 kann auch in einlagiger Weise betrieben werden, wie dies in Fig. 6b gezeigt ist. Dabei ergibt sich eine Gradientenstärke von 9 mT/m und eine Anstiegszeit von 200 µs. Gleiche Werte bei verringertem Widerstand ergeben sich bei der Schaltung nach Fig. 6c.

Dieses Beispiel zeigt besonders deutlich den Vorteil der Erfindung, daß ohne Änderung des apparativen Aufbaus durch einfaches Umschalten oder Umklemmen eine Reihe von Gradientenstärken, Anstiegszeiten und Linearitätsvolumina je nach Anforderung des Experimentators eingestellt werden kann.

Tabelle 3 zeigt Zahlenangaben zu den Schaltungen der Fig. 6.

Tabelle 3

|  | IA | IB | IC | ID | dBz/dz | R | U (stat) | τ |
|---|---|---|---|---|---|---|---|---|
| a) Spulen A,B,C,D 2 Lagen, Serie | 40A | -40A | 40A | -40A | 17,7mT/m | 0,32Ω | 12,7V | 820µs |
| b) Spulen A,B,C,D 1 Lage Serie | 40A | -40A | 40A | -40A | 8,9mT/m | 0,16Ω | 6,4V | 200µs |
| c) Spulen A,B,C,D 2 Lagen parallel | 40A | -40A | 40A | -40A | 8,9mT/m | 0,08Ω | 3,2V | 200µs |

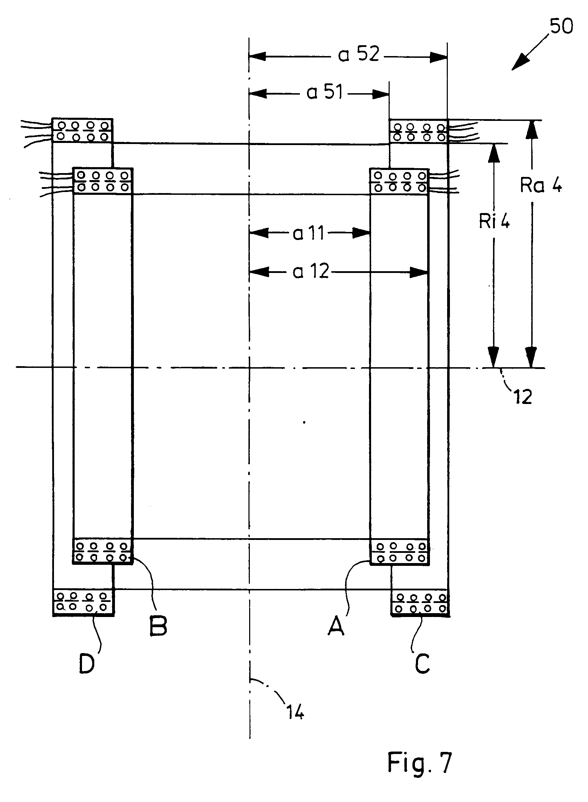

Das in Fig. 7 gezeigte Ausführungsbeispiel einer Spulenanordnung 50 mit vier Spulen A bis D enthält wiederum die gleiche Spulenanordnung A, B wie in Fig. 1 dargestellt. Fig. 7 zeigt die Verwirklichung der Erfindung bei einem aktiv abgeschirmten System. Die Spulen C und D sind im wesentlichen radial außerhalb der Spulen A und B angeordnet und überlappen diese teilweise in axialer Richtung.

Im speziellen Ausführungsbeispiel haben die Spulen C und D, die wiederum symmetrisch zur Quermittelebene 14 angeordnet sind, einen Außenradius Ra4 von 108,3 mm und einen Innenradius Ri4 von 103,9 mm. Der Abstand a51 von der Quermittelebene beträgt 59 mm, der Abstand a52 von der Quermittelebene 14 beträgt 91 mm, entsprechend einer Breite der Spulen C und D von jeweils 32 mm.

Die Spulen A und B sind wieder jeweils zweilagig mit zwei mal 13, also insgesamt 26 Windungen, und die Spulen C und D haben jeweils zwei Lagen mit je 5 Windungen, also jeweils 10 Windungen. Auch hier sind, wie bei allen übrigen Beispielen, die Anschlüsse der einzelnen Windungen oder allgemeinen Wicklungsabschnitte getrennt herausgeführt, so daß die Spulen und Wicklungsabschnitte in jeder gewünschten Weise verschaltet werden können.

Die Ampere-Windungszahl auf dem von den Spulen C und D gebildeten äußeren Schirm ist so bemessen, daß sich eine optimale Abschirmwirkung außerhalb des Gradientenraumes ergibt, wie dies nach dem Stand der Technik an sich bekannt ist.

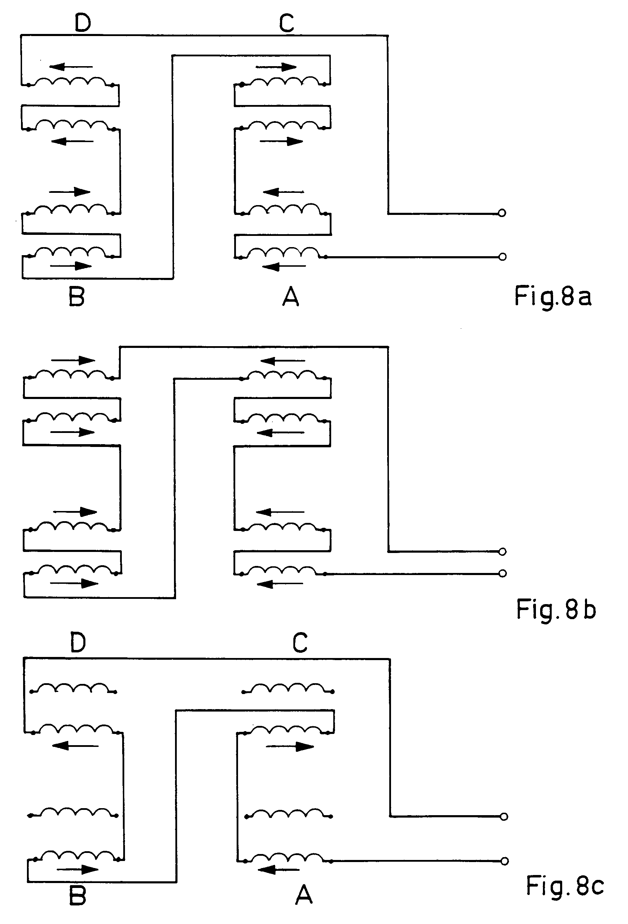

Fig. 8 zeigt drei bevorzugte Betriebsweisen der Anordnung 50 der Fig. 7. Bei der Schaltung.nach Fig. 8a sind die Spulen A und B unten gezeichnet und die Spulen C und D oben. Alle Lagen von sämtlichen Spulen sind in Serie geschaltet, wobei die inneren Spulen A und B so betrieben werden, wie dies auch in Fig. 2a gezeigt ist und die äußeren Spulen C und D als Abschirmung wirken. Bei dieser Betriebsart ergeben sich gegenüber dem Fall der Fig. 2a etwas kleinere Gradientenstärken und Induktivitäten und somit etwas kürzere Anstiegszeiten. Verwendet man ähnlich wie bei anderen oben beschriebenen Beispielen jeweils nur eine Lage der Spulen A und B und nur eine Lage der Spulen C und D, wobei die letztgenannten Spulen ebenfalls zur Abschirmung dienen, vgl. hierzu Fig. 8c, so erhält man bei gleicher Abschirmwirkung die halbe Gradientenstärke und eine Reduktion der Anstiegszeit um den Faktor 4. Die größte Gradientenstärke wird durch Hintereinanderschalten sämtlicher Spulen A bis D mit ihren sämtlichen Lagen in der Weise erreicht, daß sich die Magnetfelder der Spulen A bis D addieren, wie dies in Fig. 8b gezeigt ist. Bei dieser Schaltung ist das System nach außen nicht abgeschirmt.

Tabelle 4 zeigt Zahlenangaben zu den drei Schaltungen der Fig. 8.

Tabelle 4

|  | IA | IB | IC | ID | dBz/dz | L | R | U (stat) | τ |
|---|---|---|---|---|---|---|---|---|---|
| a) Spulen A,B,C,D 2 Lagen, abgesch. | 40A | −40A | 40A | −40A | 9,9mT/m | 280µH | 0,25Ω | 10V | 280µs |
| b) Spulen A,B,C,D 2 Lagen | 40A | −40A | 40A | −40A | 16,8mT/m | 550µH | 0,25Ω | 10V | 550µs |
| c) Spulen A,B,C,D 1 Lage abgesch. | 40A | −40A | 40A | −40A | 5,0mT/m | 70µH | 0,125Ω | 5V | 70µs |

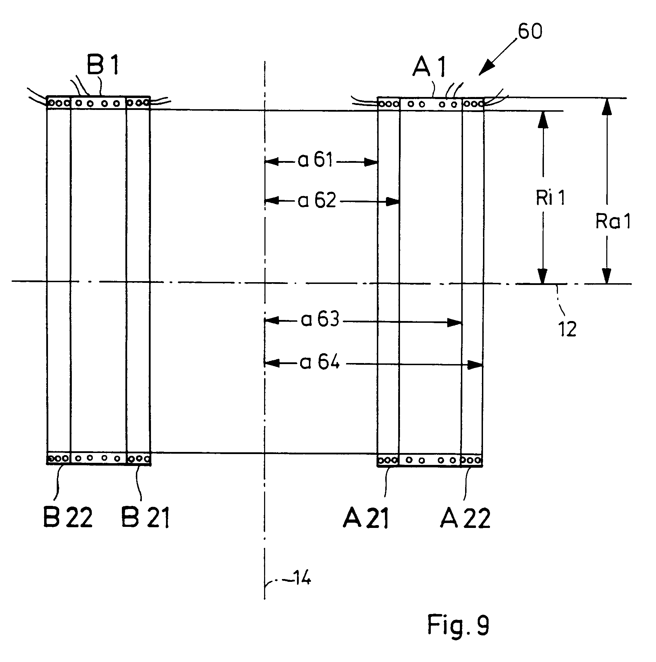

Bei der in Fig. 9 gezeigten Anordnung sind anstatt von getrennten Wicklungslagen in Axialrichtung hintereinander angeordnete, voneinander getrennte Teilspulen vorgesehen, die in der jeweils gewünschten Weise miteinander verschaltet werden können. Alle Teilspulen haben den gleichen Innenradius Ri1 und den gleichen Außenradius Ra1. Eine im Beispiel einlagige Spule A1 und eine gleich ausgebildete Spule B1 sind bezüglich der Quermittelebene 14 symmetrisch angeordnet. Unmittelbar anliegend an den genannten Spulen A1 und B1 sind zur Quermittelebene 14 hin eine Spule A21 bzw. B21 angeordnet, und an der der Quermittelebene 14 abgewandten Seite der Spulen A1 und B1 sind je eine Spule A22 bzw. B22 angeordnet. Es sind somit sechs Teilspulen vorhanden, bei denen jeweils die Wicklungsanschlüsse nach außen geführt sind.

Im Beispiel werden die Teilspulen A21 und A22 stets in Serie geschaltet betrieben und können daher als eine einzige Teilspule A2 aufgefaßt werden. Entsprechendes gilt für die Teilspulen B21 und B22. In einem speziellen Ausführungsbeispiel weist die Anordnung nach Fig. 9 folgende Abmessungen auf: Ri1 = 76,4 mm; Ra1 = 78,6 mm; a61 = 54,2 mm; a62 = 59,0 mm; a63 = 79,8 mm; a64 = 84,6 mm.

Die Spulen A1 und B1 haben jeweils 13 Windungen, die Teilspulen A21, A22, B21, B22 haben jeweils drei Windungen.

Wenn die Windungszahlen der Teilspulen A21 und A22 einerseits sowie B21 und B22 andererseits unterschiedlich gewählt werden, so versteht es sich, daß hierdurch die Anzahl der erzeugbaren Gradientenstärken gegenüber dem Beispiel der Fig. 9 zunimmt.

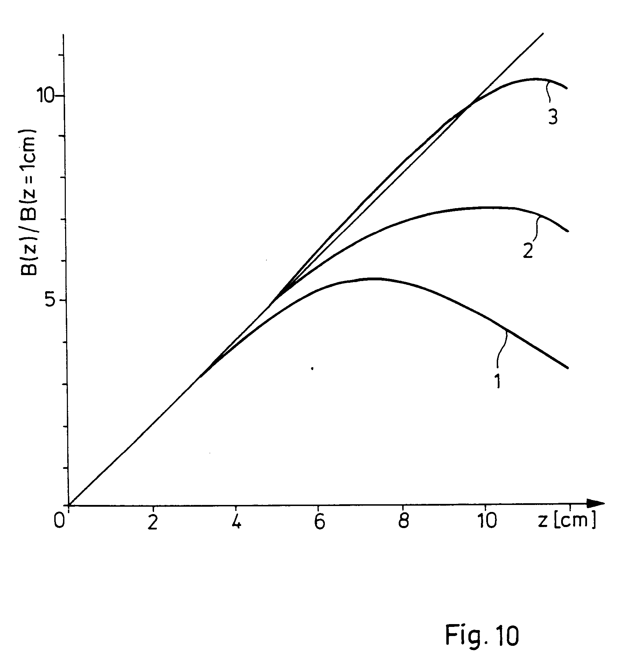

Fig. 10 zeigt den auf den Abstand z = 1 cm normierten Verlauf der Feldstärke in der Achse 12 für je eine spezielle Schaltungsanordnung der in den Fig. 1, 3 und 5 gezeigten Spulenanordnungen.

Fig. 11 zeigt entsprechend die relative Gradientenstärke für die gleichen Schaltungen wie Fig. 10.

Die jeweils mit der Ziff. 1 bezeichnete Kurve in Fig. 10 und 11 bezeichnet den Verlauf bei der Schaltung gemäß Fig. 2a mit dem hierzu in Tabelle 1 angegebenen Werten. Die mit 2 bezeichneten Kurven beziehen sich auf die Anordnung gemäß Fig. 5 und die Schaltung gemäß Fig. 6a mit den zugehörigen Werten der Tabelle 3. Die mit der Ziffer 3 bezeichneten Kurven beziehen sich auf die Spulenanordnung nach Fig. 3 mit der Schaltungsanordnung nach Fig. 4a mit den zugehörigen Werten der Tabelle 4.

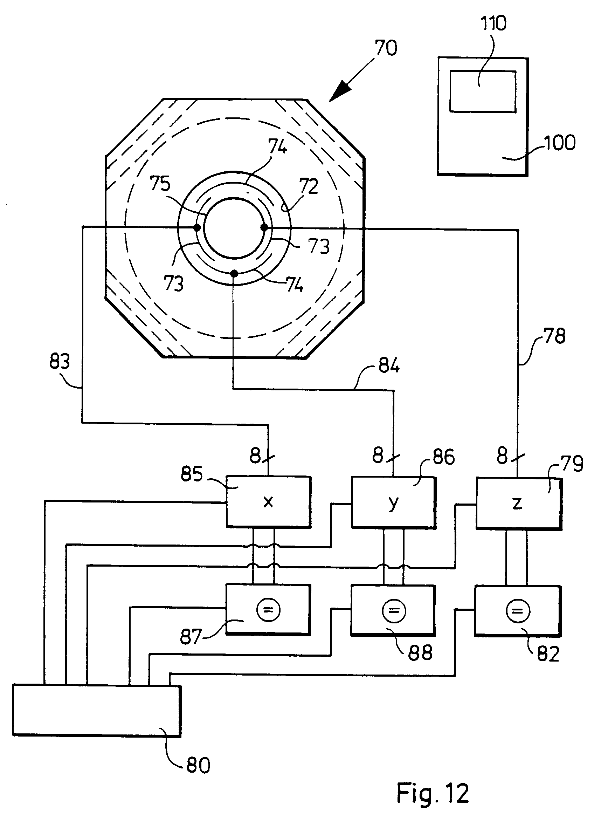

Fig. 12 zeigt schematisch in einer Endansicht das Magnetsystem 70 eines Kernspintomographen. Das Magnetsystem 70 weist eine supraleitende Spule auf, die das Feld Bo rechtwinklig zur Zeichenebene der Fig. 12 erzeugt. In der Bohrung 72 des Magnetsystems befindet sich ein zur Vereinfachung der Zeichnung nicht dargestelltes Kunststoffrohr, auf dem Gradientenspulen 73 zur Erzeugung des x-Gradienten, Gradientenspulen 74 zur Erzeugung des y-Gradienten und Gradientenspulen 75 zur Erzeugung des z-Gradienten aufgebracht sind. Im Beispiel sind als Gradientenspulen 75 für den z-Gradienten die in Fig. 1 gezeigten Spulen vorgesehen.

Die insgesamt acht Anschlüsse der einzelnen Lagen S1 und S2 der beiden in Fig.1 mit dem Buchstaben A und B bezeichneten Spulen sind über ein achtadriges Kabel 78, das zeichnerisch stark vereinfacht dargestellt ist, zu acht Ausgängen einer steuerbaren Schaltvorrichtung 79 geführt. Ein Steuereingang der Schaltvorrichtung 79 steht mit einem Steuerausgang eines Pulssteuergeräts 80 in Verbindung. Die Schaltvorrichtung 79 steht über zwei Leitungen mit einem steuerbaren Netzgerät 82 in Verbindung, dessen Steuereingang ebenfalls mit einem Ausgang des Pulssteuergeräts 80 verbunden ist. In ähnlicher Weise sind die Spulen für den x-Gradienten und den y-Gradienten durch entsprechende achtadrige Kabel 83 und 84 mit steuerbaren Schaltvorrichtungen 85 bzw. 86 verbunden, die jeweils mit einem Netzgerät 87 bzw. 88 verbunden sind. Auch die Schaltvorrichtungen 85 und 86 und die Netzgeräte 87 und 88 werden von dem Pulssteuergerät 80 gesteuert.

Für die Erzeugung des x-Gradienten und y-Gradienten werden in an sich bekannter Weise für jeden dieser Gradienten vier Sattelspulen verwendet, von denen ein Paar in z-Richtung, also rechtwinklig zur Zeichenebene, hintereinander angeordnet ist und das andere Paar diesen gegenüberliegen. Im Gegensatz zum Stand der Technik sind diese Sattelspulen so aufgebaut, daß die Sattelspulen in einen inneren und einen äußeren Wicklungsabschnitt unterteilt sind, daß jeweils diese inneren Wicklungsabschnitte der beiden Sattelspulen eines Paares für einen bestimmten Gradienten (x- oder y-Gradient) untereinander verbunden und mit zwei Anschlüssen nach außen geführt sind und daß die äußeren Wicklungsabschnitte oder Lagen desselben Paares ebenfalls miteinander verbunden sind und mit zwei Anschlüssen nach außen geführt sind. Die Sattelspulen für einen bestimmten Gradienten sind somit in ähnlicher Weise unterteilt wie in Fig. 1 dargestellt. Die insgesamt acht Anschlüsse der Sattelspulen für den x-Gradienten sind mit der Schaltvorrichtung 85 verbunden und können dort in genau der gleichen Weise wie dies für die Spulenanordnung 10 der Fig. 1 erläutert wurde, in unterschiedlicher Weise geschaltet werden, um entweder einen maximalen Gradienten bei maximaler Induktivität und auch relativ großer Anstiegszeit oder eine geringere Induktivität bei vergrößertem Linearitätsbereich und kleinerer Anstiegsdauer zu erhalten. Gleiches gilt für die Spulen 74 zur Erzeugung des y-Gradienten, die sich von den Spulen für den x-Gradienten im wesentlichen nur dadurch unterscheiden, daß sie bezüglich der z-Achse um 90° versetzt angeordnet sind.

Eine Rechenvorrichtung 100, die auch die Pulssteuervorrichtung 80 steuert, empfängt in bekannter Weise Meßsignale von den sich in magnetischer Resonanz befindenden Molekülen einer zu messenden Probe und ermöglicht eine Darstellung der Meßergebnisse als Bild auf dem Schirm 110 eines Sichtgeräts.

Das Pulssteuergerät 80 steuert die Netzgeräte 87, 88. 82 entsprechend den jeweiligen Erfordernissen und steuert auch die jeweils erforderliche Schaltstellung der Schaltvorrichtungen 85, 86, 79 entsprechend den jeweiligen Anforderungen. Auf diese Weise können selbst innerhalb einer einzigen Messung, die insgesamt eine Zeitdauer von einigen Sekunden einnehmen kann, die Netzgeräte in an sich bekannter Weise impulsweise eingeschaltet werden, wobei die Stromrichtung bei Bedarf auch umgekehrt werden kann, und je nach den Erfordernissen kann durch die gesteuerte Betätigung der Schaltvorrichtungen dafür gesorgt werden, daß entsprechend den jeweiligen Anforderungen die einzelnen Gradienten zum Beispiel entweder möglichst stark und dabei hinreichend linear oder aber verhältnismäßig schwach und hochlinear sind, wobei im letzten Fall auch eine geringere Anstiegszeit der Ströme in den einzelnen Gradientenspulen und somit des Gradientenfelds möglich ist.

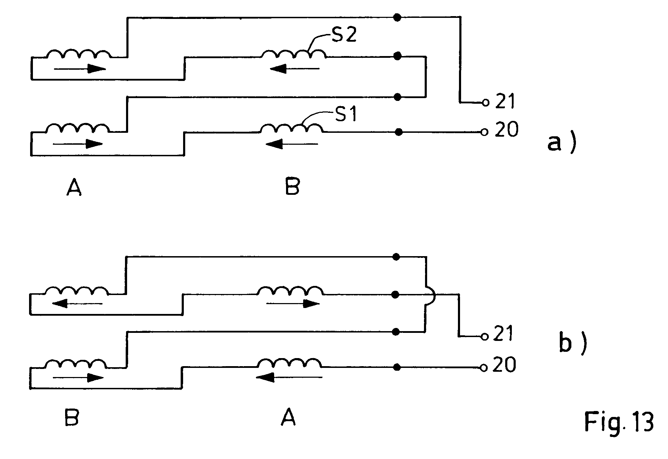

Fig 13a zeigt eine Abwandlung der Schaltung nach Fig. 2a, wobei sich die gleiche Gradientenstärke (bei Verwendung gleicher Spulen und des gleichen Stroms) wie in Fig. 2a ergibt. Hier sind beide Wicklungsabschnitte S1 direkt und nicht leicht lösbar elektrisch verbunden, und das gleiche gilt für die Verbindung zwischen den beiden Wicklungsabschnitten S2. Dies gilt auch für die in Fig. 13b gezeigte Schaltung, bei der aber die Gradientenstärke kleiner ist, weil hier die Abschnitte S2 im Vergleich zu den Abschnitten S1 in entgegengesetzter Richtung von dem Strom, der alle Wicklungsabschnitte S1 und S2 seriell durchfließt, durchflossen werden.

Die geschilderten unterschiedlichen Gradienten können je nachdem, ob ein Schichtgradient oder ein Dephasierungsgradient oder ein Auslesegradient erzeugt werden soll, jeweils unterschiedlich sein.

Je nach Bedarf können für die Gradientenspulen Spulen verwendet werden, die einen quasi-kontinuierlichen Verlauf der Stromdichte auf einem Zylindermantel nachbilden. Ein Beispiel solcher Spulen mit minimaler Induktivität ist in EP-A-320 285 bzw. Robert Turner, Minimum inductance coils, J. Phys. E: Sci. Instrum. 21 (1988), Seite 948 - 952, beschrieben.

## Patentansprüche

1. System von durch ein Netzgerät gespeisten Gradientenspulen zum Erzeugen magnetischer Gradientenfelder, die sich dem statischen Magnetfeld eines Kernspintomographen zeitweise überlagern, welches mindestens ein Paar von Gradientenspulen umfaßt, die im Betrieb in Serie von Strom durchflossen werden und in einem vorgegebenen Untersuchungsvolumen ein wenigstens näherungsweise mit dem Ort in einer Richtung linear variierendes Gradientenmagnetfeld erzeugen, wobei jede Gradientenspule (A, B) einen ersten Wicklungsabschnitt oder einen ersten Satz (S1) von Wicklungsabschnitten und einen zweiten Wicklungsabschnitt oder einen zweiten Satz (S2) von Wicklungsabschnitten aufweist, wobei die Anschlüsse (16, 17) des ersten Wicklungsabschnittes oder ersten Satzes (S1) von Wicklungsabschnitten von den Anschlüssen (18, 19) des zweiten Wicklungsabschnittes oder zweiten Satzes (S2) von Wicklungsabschnitten getrennt sind,

dadurch gekennzeichnet, daß der erste Wicklungsabschnitt oder erste Satz (S1) von Wicklungsabschnitten durch eines der folgenden Mittel in unterschiedlicher Weise mit dem zweiten Wicklungsabschnitt oder zweiten Satz (S2) von Wicklungsabschnitten verbindbar und von diesem trennbar ist: Umlöten von Wicklungsanschlüssen, wobei diese Wicklungsanschlüsse für den Benutzer leicht zugänglich angeordnet sein müssen, eine Umsteckvorrichtung, eine Schaltvorrichtung (24; 79, 85, 86).

2. System nach Anspruch 1, mit mindestens einem Gradientennetzgerät zum zeitweisen Erzeugen eines elektrischen Stroms, dadurch gekennzeichnet, daß die beiden Sätze (S1, S2) mindestens eines Paares von Gradientenspulen mit dem Gradientennetzgerät (22; 82,87,88) in einer Weise verbindbar sind, die es gestattet, in einer ersten Betriebsart die beiden Sätze mit ersten Strömen I1 bzw. I2 zu beschicken und in einer zweiten Betriebsart die beiden Sätze mit zweiten Strömen I1′ und I2′ zu beschicken, wobei in beiden Betriebsarten das von der Kombination aller ersten und zweiten Sätze erzeugte Gradientenmagnetfeld im Untersuchungsvolumen wenigstens näherungsweise in einer Richtung linear mit dem Ort variiert und die in der ersten und der zweiten Betriebsart erzeugten Gradientenfelder voneinander verschieden sind.

3. System nach Anspruch 2, dadurch gekennzeichnet, daß der Strom durch einen der Sätze in der zweiten Betriebsart Null ist.

4. System nach Anspruch 2, dadurch gekennzeichnet, daß der Strom durch einen bestimmten Satz in der ersten Betriebsart entgegengesetzt zu dem Strom gerichtet ist, der in der zweiten Betriebsart den zweiten Satz durchfließt.

5. System nach Anspruch 4, dadurch gekennzeichnet, daß der Absolutwert der beiden den bestimmten Satz durchfließenden Ströme in beiden Betriebsarten gleichgroß ist.

6. System nach einem der vorhergehenden Ansprüche, dadurch gekennzeichnet, daß in einer Betriebsart die beiden Sätze in Serie geschaltet sind.

7. System nach Anspruch 6, dadurch gekennzeichnet, daß die beiden Sätze in der anderen Betriebsart ebenfalls in Serie geschaltet sind, wobei jedoch die Anschlüsse genau eines der Sätze gegenüber der ersten Betriebsart vertauscht sind.

8. System nach Anspruch 6 oder 7, dadurch gekennzeichnet, daß die ersten Wicklungsabschnitte (S1, S1) beider Gradientenspulen (A, B) des Paars miteinander fest in Serie geschaltet sind, und daß die zweiten Wicklungsabschnitte (S2, S2) beider Gradientenspulen (A, B) des Paars miteinander fest in Serie geschaltet sind.

9. System nach einem der vorhergehenden Ansprüche, dadurch gekennzeichnet, daß für mindestens zwei orthogonal zueinander gerichtete Gradienten Gradientenspulen (73,74,75) vorgesehen sind, die in Sätze unterteilt sind.

10. System nach Anspruch 9, dadurch gekennzeichnet, daß für drei zueinander orthogonale Gradientenrichtungen Gradientenspulen (73,74,75) vorgesehen sind, die jeweils in Sätze unterteilt sind, und daß die Gradienten-Richtung eines der Gradientenfelder mit der Richtung des statischen Magnetfelds wenigstens näherungsweise parallel verläuft.

11. System nach einem der vorhergehenden Ansprüche, dadurch gekennzeichnet, daß die Schaltvorrichtung (79, 85, 86) steuerbar ist.

12. System nach Anspruch 2 oder einem der Ansprüche 3 bis 11, soweit sie auf Anspruch 2 rückbezogen sind, dadurch gekennzeichnet, daß zwei innere Spulen (A, B) und zwei im wesentlichen radial außerhalb der inneren Spulen (A, B) angeordnete äußere Spulen (C, D) vorgesehen sind, und daß die beiden Betriebsarten derart gewählt sind, daß in der einen Betriebsart im Außenraum des Gradientenerzeugungssystems für eine Gradientenrichtung das durch das Gradientenerzeugungssystem erzeugte Magnetfeld weitgehend kompensiert wird, und daß in der anderen Betriebsart die von den beiden Sätzen in ihrem Zentrum

11

erzeugten magnetischen Gradientenfelder gleichgerichtet sind.

13. System nach einem der vorhergehenden Ansprüche, dadurch gekennzeichnet, daß die Gradientenspulen zylinderförmig sind bzw. auf einem zylinderförmigen Träger aufgebracht sind, und daß der erste und der zweite Satz einen verschiedenen Radius haben.

14. System nach einem der Ansprüche 1 bis 12, dadurch gekennzeichnet, daß die Gradientenspulen zylinderförmig sind bzw. auf einem zylinderförmigen Träger aufgebracht sind, und daß der erste und der zweite Satz den gleichen Radius haben und vorzugsweise in Axialrichtung der Gradientenspule hintereinander angeordnet sind.

15. System nach einem der vorhergehenden Ansprüche, dadurch gekennzeichnet, daß in Sätze unterteilte Sattelspulen vorgesehen sind.

16. System nach einem der Ansprüche 1 bis 14, dadurch gekennzeichnet, daß in Sätze unterteilte Spulen mit einem quasi-kontinuierlichen Verlauf der Stromdichte auf einem Zylindermantel vorgesehen sind.

17. Kernspintomograph, dadurch gekennzeichnet, daß er ein System nach einem der vorhergehenden Ansprüche aufweist.

18. Verfahren zur Bilderzeugung mit einem Kernspintomographen, der eine Einrichtung (80) zur programmierten Ansteuerung eines Gradientennetzgeräts (82,87,88) und eine steuerbare Schaltvorrichtung (79,85,86) aufweist, dadurch gekennzeichnet, daß der Kernspintomograph nach Anspruch 17 und die Schaltvorrichtung nach Anspruch 11 ausgebildet sind, und daß die Schaltvorrichtung (79,85,86) während einer Messung von Daten zum Gewinnen der Bildelemente von der Einrichtung (80) zur programmierten Ansteuerung so gesteuert wird, daß durch Umschalten zwischen verschiedenen Betriebsarten der Gradientenspulenanordnung die von den Wicklungsabschnitten bzw. Sätzen von Wicklungsabschnitten erzeugten Teilfelder sich im Verlauf der Messung in unterschiedlicher Weise zu einem resultierenden Gradientenfeld im Innern der Anordnung überlagern.

## Claims

1. System of gradient coils powered from a power supply for the generation of magnetic gradient fields which intermittently overlap the static magnetic field of a nuclear-spin tomograph, with at least one pair of gradient coils, through which current flows in series when in operation and which generate, in a predefined volume under examination, a gradient magnetic field that varies at least approximately in linear fashion with position in one direction, with each gradient coil (A, B) having a first winding zone or a first set (S1) of winding zones and a second winding zone or a second set (S2) of winding zones, wherein the terminals (16, 17) of the first winding zone or first set (S1) of winding zones are separated from the terminals (18, 19) of the second winding zone or second set (S2) of winding zones, characterized in that the first winding zone or first set (S1) of winding zones can be connected to or disconnected from the second winding zone or second set (S2) of winding zones in varying ways by means of one of the following means: resoldering of winding terminals, wherein these winding terminals have to be arranged such that they are easily accessible by the user; a plug-changing device; a switching device (24; 79, 85, 86).

2. System according to Claim 1, with at least one gradient power supply for intermittently generating an electrical current, characterized in that the two sets (S1, S2) of at least one pair of gradient coils can be connected to the gradient power supply (22; 82, 87, 88) in a manner which makes it possible, in a first operating mode, to deliver first currents I1 and I2 to the two sets, and in a second operating mode to deliver second currents I1′ and I2′ to the two sets, such that in the two operating modes, the gradient magnetic field generated by the combination of all first and second sets in the volume under examination varies at least approximately in one direction in linear fashion with position, and the gradient fields generated in the first and the second operating mode are different from one another.

3. System according to Claim 2, characterized in that the current through one of the sets is zero in the second operating mode.

4. System according to Claim 2, characterized in that the current through a specific set in the first operating mode is oriented opposite to the current that flows through the second set in the second operating mode.

5. System according to Claim 4, characterized in that the absolute value of the two currents flowing through the specific set in the two operating modes is identical.

6. System according to one of the preceding Claims, characterized in that in one operating mode, the two sets are connected in series.

7. System according to Claim 6, characterized in that in the other operating mode, the two sets are also connected in series, although the terminals of exactly one of the sets are transposed as compared with the first operating mode.

8. System according to Claim 6 or 7, characterized in that the first winding zones (S1, S1) of both gradient coils (A, B) of the pair are permanently connected to one another in series, and wherein the second winding zones (S2, S2) of both gradient coils (A, B) of the pair are permanently connected to one another in series.

9. System according to one of the preceding Claims, characterized in that gradient coils (73, 74, 75) that are subdivided into sets are provided for at least two gradients oriented orthogonally to one another.

10. System according to Claim 9, characterized in that gradient coils (73, 74, 75) that are each subdivided into sets are provided for three gradient directions that are orthogonal to one another, and wherein the gradient direction of one of the gradient fields runs at least approximately parallel to the direction of the static magnetic field.

11. System according to one of the preceding Claims, characterized in that the switching device (79, 85, 86) is controllable.

12. System according to Claim 2 or one of claims 3 to 11, in as far as they depend on claim 2, characterized in that two inner coils (A, B) and two outer coils (C, D) arranged essentially radially outside the inner coils (A, B) are provided and that the two operating modes are selected so that in the one operating mode, the magnetic field generated by the gradient-generation system is largely compensated for in the outer volume of the gradient-generation system for one gradient direction, and wherein in the other operating mode, the magnetic gradient fields generated by the two sets in their center are oriented in the same direction.

13. System according to one of the preceding Claims, characterized in that the gradient coils are cylindrically shaped or respectively mounted on a cylindrically shaped support and that the first and the second set have a different radius.

14. System according to one of Claims 1 to 12, characterized in that the gradient coils are cylindrically shaped or respectively mounted on a cylindrically shaped support and that the first and the second set have the same radius and preferably are arranged behind one another in the axial direction of the gradient coil.

15. System according to one of the preceding Claims, characterized in that saddle coils subdivided into sets are provided.

16. System according to one of Claims 1 to 14, characterized in that coils subdivided into sets, with a quasi-continuous profile for the current density over a cylindrical enveloping surface, are provided.

17. Nuclear-spin tomograph, characterized in that it has a system according to one of the preceding Claims.

18. Process for the generation of images with a nuclear-spin tomograph, which has a device (80) for the programmed control of a gradient power supply (82, 87, 88) and a controllable switching device (79, 85, 86), characterized in that the nuclear-spin tomograph is formed according to claim 17 and the switching device is formed according to claim 11, and that during a measurement of data to obtain the picture elements, the switching device (79, 85, 86) is controlled by the device (80) for programmed control in such a way that by switching over between different operation modes of the gradient coil arrangement, the partial fields generated by the winding zones or sets of winding zones, respectively, overlap one another during the measurement in different ways to form a resulting gradient field in the inside of the arrangement.

**Revendications**

1. Système de bobines à champ variable alimentées par une boîte de courant pour engendrer des champs magnétiques variables qui se superposent dans le temps au champ magnétique statique d'un appareil de tomographie par résonance magnétique nucléaire comprenant au moins une paire de bobines à champ variable, celles-ci étant traversées en série par le courant lors du fonctionnement et engendrant dans un volume d'examen prédéterminé un champ magnétique variable qui varie linéairement avec la position dans une direction, du moins approximativement, cependant que chaque bobine à champ variable (A, B) comprend une première partie d'enroulement ou un premier jeu (S1) de parties d'enroulement et une deuxième partie d'enroulement ou un deuxième jeu (S2) de parties d'enroulement, et que les connexions (16, 17) de la première partie d'enroulement ou du premier jeu (S1) de parties d'enroulement sont séparées des connexions (18, 19) de la deuxième partie d'enroulement ou du deuxième jeu (S2) de parties d'enroulement, caractérisé par le fait que la première partie d'enroulement ou le premier jeu (S1) de parties d'enroulement peut être relié d'une manière différente à la deuxième partie d'enroulement ou au deuxième jeu (S2) de parties d'enroulement et qu'il peut en être séparé grâce à l'un des moyens suivants : une permutation par soudage des connexions des enroulements, ces connexions des enroulements devant être disposées de façon à être facilement accessibles à l'utilisateur, un dispositif de permutation par des fiches et un dispositif de commutation (24 ; 79, 85, 86).

2. Système selon la revendication 1, comprenant au moins une boîte à courant pour engendrer dans le temps un courant électrique, caractérisé par le fait que les deux jeux (S1, S2) d'au moins une paire de bobines à champ variable peuvent être reliés à la boîte de courant affectée au champ variable (22 ; 82, 87, 88) d'une manière qui permet d'alimenter les deux jeux au moyen de premiers courants I1 et I2, respectivement, dans un premier mode de fonctionnement, et d'alimenter les deux jeux au moyen de deuxièmes courants I1' et I2', respectivement, dans un deuxième mode de fonctionnement, cependant que, dans les deux modes de fonctionnement, le champ magnétique variable qui est engendré dans le volume d'examen par la combinaison de tous les premiers et deuxièmes jeux varie linéairement avec la position dans une direction, du moins approximativement, et que les champs variables engendrés dans le premier mode de fonctionnement et dans le deuxième diffèrent entre eux.

3. Système selon la revendication 2, caractérisé par le fait que le courant à travers l'un des jeux est égal à zéro dans le deuxième mode de fonctionnement.

4. Système selon la revendication 2, caractérisé par le fait que le courant qui passe à travers un jeu déterminé dans le premier mode de fonctionnement est dirigé en sens inverse par rapport au courant qui traverse le deuxième jeu dans le deuxième mode de fonctionnement.

5. Système selon la revendication 4, caractérisé par le fait que la valeur absolue des deux courants qui traversent le jeu déterminé est la même dans les deux modes de fonctionnement.

6. Système selon l'une des revendications précédentes, caractérisé par le fait que les deux jeux sont montés en série dans un mode de fonctionnement.

7. Système selon la revendication 6, caractérisé par le fait que les deux jeux sont également montés en série dans l'autre mode de fonctionnement, les connexions de l'un des jeux étant toutefois permutées par rapport au premier mode de fonctionnement.

8. Système selon la revendication 6 ou 7, caractérisé par le fait que les premières parties d'enroulement (S1, S1) des deux bobines à champ variable (A, B) de la paire sont reliées entre elles en série d'une manière fixe, et par le fait que les deuxièmes parties d'enroulement (S2, S2) des deux bobines à champ variable (A, B) de la paire sont reliées entre elles en série d'une manière fixe.

9. Système selon l'une des revendications précédentes, caractérisé par le fait que, pour au moins deux champs variables dirigés perpendiculairement l'un à l'autre, il est prévu des bobines à champ variable (73, 74, 75) qui sont divisées en jeux.

10. Système selon la revendication 9, caractérisé par le fait que, pour trois directions de champs variables perpendiculaires entre elles, il est prévu des bobines à champ variable (73, 74, 75) qui sont chacune divisées en jeux, et par le fait que la direction de l'un des champs variables s'étend parallèlement à la di-

EP 0 500 618 B1

rection du champ magnétique statique, du moins approximativement.

**11.** Système selon l'une des revendications précédentes, caractérisé par le fait que le dispositif de commutation (79, 85, 86) peut être asservi.

**12.** Système selon la revendication 2 ou selon l'une des revendications 3 à 11, pour autant qu'elle renvoie à la revendication 2, caractérisé par le fait qu'il est prévu deux bobines intérieures (A, B) et deux bobines extérieures (C, D) qui sont disposées pour l'essentiel à l'extérieur des bobines intérieures (A, B) dans le sens radial, et par le fait que les deux modes de fonctionnement sont choisis d'une manière telle que, dans l'un des modes de fonctionnement, le champ magnétique engendré par le système engendrant le champ variable soit largement compensé dans le volume extérieur du système engendrant le champ variable, pour une direction du champ variable, et que, dans l'autre mode de fonctionnement, les champs magnétiques variables engendrés par les deux jeux au centre de ceux-ci soient dirigés dans le même sens.

**13.** Système selon l'une des revendications précédentes, caractérisé par le fait que les bobines à champ variable sont en forme de cylindre ou, respectivement, qu'elles sont montées sur un support cylindrique, et par le fait que le premier jeu et le deuxième jeu présentent un rayon différent.

**14.** Système selon l'une des revendications 1 à 12, caractérisé par le fait que les bobines à champ variable sont en forme de cylindre ou, respectivement, qu'elles sont montées sur un support cylindrique, et par le fait que le premier jeu et le deuxième jeu présentent le même rayon, en étant disposés de préférence l'un derrière l'autre dans la direction axiale de la bobine à champ variable.

**15.** Système selon l'une des revendications précédentes, caractérisé par le fait qu'il est prévu des bobines en forme de selles qui sont divisées en jeux.

**16.** Système selon l'une des revendications 1 à 14, caractérisé par le fait que des bobines divisées en jeux sont prévues sur une enveloppe cylindrique en présentant une courbe pratiquement continue pour la densité du courant.

**17.** Appareil de tomographie par résonance magnétique nucléaire, caractérisé par le fait qu'il comprend un système selon l'une des revendications précédentes.

**18.** Procédé pour engendrer des images au moyen d'un appareil de tomographie par résonance magnétique nucléaire qui comprend un dispositif (80) pour exciter d'une manière programmée une boîte à courant affectée au champ variable (82, 87, 88), ainsi qu'un dispositif de commutation (79, 85, 86) qui peut être asservi, caractérisé par le fait que l'appareil de tomographie par résonance magnétique nucléaire est conformé selon la revendication 17 et que le dispositif de commutation l'est selon la revendication 11, et par le fait que le dispositif de commutation (79, 85, 86), pendant une mesure de données destinées à l'obtention d'éléments d'images, est commandé par le dispositif d'excitation programmée (80) d'une manière telle que, par permutation entre des modes de fonctionnement différents du dispositif à bobines à champ variable, les champs partiels qui sont engendrés par les parties d'enroulement ou par les jeux de parties d'enroulement, respectivement, se superposent d'une manière différente au cours de la mesure pour donner un champ variable résultant à l'intérieur du dispositif.

15

Fig.1

Fig. 2

a)

b)

c)

Fig. 3

EP 0 500 618 B1

Fig. 4a

Fig. 4 b

Fig. 5

D B A C Fig.6a

D B A C Fig.6b

D B A C Fig.6c

Fig. 7

Fig.8a

Fig.8b

Fig.8c

Fig. 9

Fig. 10

Fig. 11

Fig. 12

S2

21
S1
20
a )

A          B

21
20
b )

B          A

Fig. 13

EP 0 500 618 B1